(19) **Europäisches Patentamt**

**European Patent Office**

**Office européen des brevets**

(11) **EP 1 076 390 A2**

(12) **EUROPEAN PATENT APPLICATION**

(43) Date of publication:
**14.02.2001 Bulletin 2001/07**

(51) Int. Cl.$^7$: **H01S 5/323**, H01L 33/00

(21) Application number: **00117226.1**

(22) Date of filing: **11.08.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **11.08.1999 JP 22728399**

(71) Applicant:
**KABUSHIKI KAISHA TOSHIBA
Kawasaki-shi, Kanagawa-ken 210-8572 (JP)**

(72) Inventor: **Okazaki, Haruhiko
Minami-ku, Yokohama-shi, Kanagawa-ken (JP)**

(74) Representative: **HOFFMANN - EITLE
Patent- und Rechtsanwälte
Arabellastrasse 4
81925 München (DE)**

(54) **Semiconductor light-emitting element and method of fabrication thereof**

(57)      The present invention makes it possible to alleviate any "mismatching" of lattice constant between a substrate and a light-emitting layer by using a light-emitting layer that is formed of alternate layers of a semiconductor having a lattice constant that is larger than that of the substrate and a semiconductor having a lattice constant that is smaller than that of the substrate. If the thickness of each layer is on the order of the wavelength of the de Broglie wave of electrons, or less than the "critical thickness" thereof, compressive stresses are applied to each layer so that the lattice constant thereof can become closer to that of the substrate, with no generation of crystal defects. If a region comprising an n-side electrode material is formed in part of a region in which a p-side electrode is formed, and is then annealed, the resultant reaction between the metals of those electrodes will form a region with a high contact resistance.

FIG. 1

Printed by Xerox (UK) Business Services
2.16.7 (HRS)/3.6

**Description**

BACKGROUND OF THE INVENTION

The present invention relates to a semiconductor light-emitting element and a method of fabrication thereof. More specifically, the present invention relates to a semiconductor light-emitting element that enables a longer wavelength, a greater brightness, and an improved reliability for a light-emitting diode (LED) or laser diode (LD) that uses a nitride semiconductor (nitride compound semiconductor).

The present invention also relates to a semiconductor light-emitting element and a method of fabrication thereof that are suitable for the formation of a current-blocking structure for an LED or an LD formed of a nitride semiconductor or other material.

It has recently become practicable to use nitride semiconductors as materials for light-emitting elements in the short-wavelength region, thus making it possible to emit light in the ultraviolet, blue, and green regions with a high emission intensity, which has been difficult up to the present. In addition, the material characteristics of a nitride semiconductor make it possible to increase the emission wavelength up to 633 nm, thus enabling emission up into the red-light range and thus making it possible to uses a nitride semiconductor instead of a gallium arsenide (GaAs) of the prior art, to implement emission within the visible-light range.

It should be noted that the term "nitride semiconductor" as used in this application comprises semiconductors of compounds of groups III to V with the generic form of $B_x In_y Al_z Ga_{(1-x-y-z)}N$ (where $0 \leqq x \leqq 1$, $0 \leqq y \leqq 1$, and $0 \leqq z \leqq 1$), and further comprises mixed crystals that include phosphorous (P) and/or arsenic (As) in addition to nitrogen (N), as group-V elements.

A schematic sectional view through a typical example of a nitride semiconductor light-emitting element of the prior art is shown in Fig. 9. A nitride semiconductor light-emitting element 100 is configured of a GaN buffer layer (not shown in the figure), an n-type GaN layer 119, a light-emitting layer 120, and a p-type GaN layer 105, formed in that sequence on top of a sapphire substrate 118. Part of the light-emitting layer 120 and the p-type GaN layer 105 are removed by etching to expose the n-type GaN layer 119. A p-side transparent electrode 106 and a current-blocking isolation film 121 are provided on top of the p-type GaN layer 105, and a p-side bonding electrode 107 connected to the p-side transparent electrode 106 is provided on top of the isolation film 121. An n-side electrode 109 is provided on top of the n-type GaN layer 119.

With this configuration, a current supplied through the p-side bonding electrode 107 spreads in the in-plane directions within the highly-conductive transparent electrode 106, the current is injected from the p-type GaN layer 105 into the light-emitting layer 120 to cause light to be generated therefrom, and this light is extracted to the exterior of the element through the transparent electrode 106.

One characteristic of the prior-art light-emitting element exemplified in Fig. 9 is the presence of a "lattice-mismatching system," in other words, there is a large difference in lattice constant between the substrate and the layer grown thereupon. The lattice constant of the sapphire used as the substrate 118 is 2.75 Å (Ångstrom units) whereas the lattice constant of GaN is 3.19 Å, so that the lattice mismatch $\Delta a/a$ therebetween is as high as 16%. In a prior-art nitride semiconductor light-emitting element, a GaN crystal comprising a large quantity of crystal defects is allowed to grow on a substrate that has such a large difference in lattice constants, and light is emitted therefrom.

With the type of nitride semiconductor material shown by way of example in Fig. 9, it is necessary to use InGaN as the material of the light-emitting layer 120, to ensure emission within a comparatively long wavelength band that covers the range from green to red. In the prior art, the light-emitting layer 120 is either formed as a single layer or a multiple quantum well (MQW) structure using InGaN well layers and GaN barrier layers is employed therefor, as disclosed in Japanese Patent Application Laid-Open No. H10-270758. To increase the emission wavelength, therefore, it is necessary to increase the indium (In) component thereof.

However, the lattice constant of InN is approximately 3.55 Å, so that increasing the indium component in InGaN will further increase the mismatch between the lattice constants of the sapphire substrate and the GaN layer. In other words, if the indium component of the light-emitting layer 120 is increased in the prior-art light-emitting element, the lattice mismatch between the sapphire substrate 118 and the GaN layers 105 and 119 that is caused by the presence of the previously described "lattice mismatching system" will increase further, which in the worst case could lead to a deterioration in the crystallinity of the light-emitting layer 120.

Since the equilibrium vapor pressure of indium is high, an increase in the indium component of the light-emitting layer 120 will cause problems in that, once the light-emitting layer has been grown, it will decompose and re-evaporate during subsequent crystal growth.

Thus, in the nitride semiconductor light-emitting element of the configuration exemplified in Fig. 9, it becomes more difficult to grow a good-quality crystal as the emission wavelength increases, leading to problems in that the emission power will drop greatly. For that reason, the upper limit of indium comprised within the $In_x Ga_{1-x}N$ compound is at most x = 0.3, which, when converted to wavelengths, imposes a restriction on emissions from blue at 450 nm to green.

One method of achieving a longer wavelength in the prior-art light-emitting element involves doping with both Zn and Si to induce light-emission through impurity energy levels. However, the broad spectrum of the emitted light make it difficult to achieve a pureness of color and the light-emission power is lower than that of the band-to-band emissions.

Not only the initial characteristics are affected. If a GaN layer is grown as a crystal on top of sapphire substrate with a large "mismatch" of lattice constants, large stresses will be imparted to the crystal even if a buffer layer is grown therebetween, so many lattice defects will be generated and there will be problems concerning the reliability of the light-emitting element, such as a deterioration in the lifetime and the long-term stability of the various characteristics thereof. This problem is particularly serious in the implementation of a high-power semiconductor laser.

In order to realize a full-color display, it is necessary to generate red, blue, and green light. The presence of the various problems described above, however, make it extremely difficult in the art to obtain the emission of bright light in the long-wavelength region, in other words, of red light, when using gallium nitride materials.

With the prior-art light-emitting element exemplified in Fig. 9, the sapphire used as the sapphire substrate 118 is not conductive, so it is necessary to form either the p-side electrode or the n-side electrode on the upper side of the light-emitting element. This increases the surface area of the chip that is necessary therefor, reducing the number of elements that can be obtained from one wafer and thus increasing the cost.

With the prior-art light-emitting element exemplified in Fig. 9, it is necessary to provide the isolation film 121 below the bonding pad 107 in order to block the flow of current, which adds complexity from the viewpoints of both configuration and fabrication.

SUMMARY OF THE INVENTION

The present invention was devised in the light of the above described technical problems. In other words, an objective thereof is to provide a semiconductor light-emitting element that makes it possible to reliably emit light of long wavelengths covering the optical range from green to red, by ensuring the reliable growth of a light-emitting layer containing a higher indium component than in the art, without any deterioration of crystallinity.

Another objective of the present invention is to provide a semiconductor light-emitting element and a method of fabrication thereof that make it possible to form a current-blocking structure both reliably and in a simple manner.

In order to achieve the above described objectives, a semiconductor light-emitting element in accordance with this invention is provided with a substrate and a light-emitting layer disposed on a main surface of the substrate; wherein the light-emitting layer comprises a first layer formed of a nitride semiconductor having a lattice constant that is larger than that of the substrate and a second layer formed of a nitride semiconductor having a lattice constant that is smaller than that of the substrate; and the first layer is compressed by the second layer in a substantially elastic manner in directions parallel to the main surface, to reduce a difference in lattice constant with respect to the substrate.

Another semiconductor light-emitting element in accordance with the invention element comprises: a semiconductor of a first conductivity type; and an electrode provided in contact with the semiconductor of the first conductivity type, a contact portion between the semiconductor and the electrode including a first region having a lower contact resistance and a second region having a higher contact resistance, a first metal that enables ohmic-like contact with respect to the semiconductor of the first conductivity type being placed in contact with the semiconductor of the first conductivity type within the first region, and a mixed body formed of the first metal and a second metal that enables ohmic-like contact with respect to a semiconductor of a second conductivity type being placed in contact with the semiconductor of the first conductivity type within the second region.

The invention also provides a method of fabricating a semiconductor light-emitting element, comprising: a first depositing step for depositing a first metal that enables ohmic-like contact with respect to a semiconductor of a first conductivity type, on an upper surface of the semiconductor of the first conductivity type; a second depositing step for depositing a second metal that enables ohmic-like contact with respect to the semiconductor if the semiconductor is of a second conductivity type, on part of the upper surface of the semiconductor of the first conductivity type; and an alloying step for forming a region with a higher contact resistance with respect to the semiconductor of the first conductivity type, by causing a reaction between the first metal and the second metal.

When implemented as described above, the present invention achieves the effects described below.

First of all, the present invention makes it possible to alleviate any mismatch in lattice constant between the substrate and the light-emitting layer by using a light-emitting layer that is formed of alternate layers of a semiconductor having a lattice constant that is larger than that of the substrate and a semiconductor having a lattice constant that is smaller than that of the substrate. If the thickness of each layer is on the order of the wavelength of the de Broglie wave of electrons, or less than the "critical thickness" thereof, compressive stresses are applied to each layer so that the lattice constant thereof can become closer to that of the substrate, with no generation of crystal defects.

These effects of the present invention are most dramatic when used for a light-emitting element having a "lattice-matching system." In other words, the mismatch between the lattice constants of the substrate and a layer grown thereupon can be made much smaller than in a prior-art structure using a sapphire substrate, by using a substate that enables lattice-matching with a GaN substrate or GaN layer, which makes it possible to greatly reduce the number of crystal defects caused by each of the grown layers, including the light-emitting layer. This "lattice-matching system" in accordance with the present invention also makes it possible to dramatically reduce the number of crystal defects caused by the InGaN layer. This makes it possible to further dramatize the effects exhibited by the lattice-matching system.

As a result, it is possible to greatly reduce the number of crystal defects in the crystal layer and boundary surfaces thereof, even if the indium component of the light-emitting layer is increased.

The present invention also makes it possible to prevent any re-evaporation or decomposition of the InGaN crystal, which causes problems during crystal growth, by growing alternate layers comprising a thin film of indium and layers comprising a thin film of aluminum, making it possible to achieve a good-quality crystal in a reliable manner. As a result, it becomes possible to implement a light-emitting layer with a higher indium component than in the prior art, thus making it possible to implement a brighter light-emitting layer in the red-light range, beyond the wavelengths of green.

To obtain emissions at even longer wavelengths, the indium components of InGaN layers sandwiched between AlGaN layers can be made to increase with increasing distance from the substrate side towards the surface, making it possible to implement a good InGaN layer with no deterioration of crystallinity caused by that increase. In particular, if the indium component of each well layer is adjusted to achieve the emission of red, blue, and green light therefrom, the resultant emission will be effectively white. It has been determined from experiments that wavelength can be controlled to a certain extent by controlling the amount of strain within each well layer, so it is possible to obtain the emission of red, blue, and green light and thus achieve an effectively white light by adjusting the indium components and lattice strains therein.

The present invention further makes it possible to form an electrode even on the rear surface of the substrate, if layers are grown on a conductive substrate such as one of GaN, thus having the effect of enabling more efficient usage of the surface area of the wafer.

A second embodiment of this invention makes it possible to form a "current-blocking structure" in a reliable and also simple manner.

These effects of the present invention are not limited to a light-emitting element formed by using a nitride semiconductor; similar effects can be achieved by applying this invention to light-emitting elements formed by using various other materials.

As described in detail above, the present invention provides a semiconductor light-emitting element and a method of fabrication thereof which make it possible to obtain the reliable emission of long-wavelength light covering the range from green to red, and which also make it possible to form a current-blocking structure in a reliable and also simple manner.

## BRIEF DESCRIPTION OF THE DRAWINGS

The present invention will be understood more fully from the detailed description given herebelow and from the accompanying drawings of the preferred embodiments of the invention. However, the drawings are not intended to imply limitation of the invention to a specific embodiment, but are for explanation and understanding only.

In the drawings:

Fig. 1 is a schematic section through a semiconductor light-emitting element in accordance with an embodiment of the present invention;
Fig. 2 is a graph showing the relationships between the lattice constants in the a-axial direction of GaN, InN, and AlN;
Figs. 3A-3D are schematic views of various lattice-matching states that occur when MQW layers are grown in an epitaxial manner on top of a GaN substrate;
Fig. 4 is a flow-chart of the fabrication process of the semiconductor light-emitting element 10A;
Fig. 5 is a graph showing the current-optical power characteristic of a light-emitting element in accordance with a first embodiment of this invention;
Fig. 6 is a schematic section through a semiconductor light-emitting element in accordance with a second embodiment of the present invention;
Fig. 7 is a schematic section through a semiconductor light-emitting element in accordance with a third embodiment of the present invention;
Fig. 8 is a schematic section through a semiconductor light-emitting element in accordance with a fourth embodiment of the present invention; and
Fig. 9 is a schematic section through a typical nitride semiconductor light-emitting element of the prior art.

## DETAILED DESCRIPTION OF PREFERRED EMBODIMENTS

A first embodiment of the present invention makes it possible to alleviate any "mismatch" in lattice constant between a light-emitting layer, which comprises at least one InGaN layer, and a GaN layer. The means of achieving this is to interpose AlGaN layers between the InGaN layers of the light-emitting layer. The lattice constant of InGaN is larger than that of GaN but the lattice constant of AlGaN is smaller than that of GaN.

It is therefore possible to adjust a light-emitting layer that is formed of an InGaN layer and an AlGaN layer in such a manner that the average lattice constant thereof is close to that of GaN. If the film thickness of each InGaN layer in this case is made to be thin enough, in other words, on the order of the wavelength of the de Broglie wave of electrons or less than the "critical thickness" thereof, compressive stresses can be applied to the InGaN layer to make the lattice constant closer to that of GaN, without generating any crystal defects.

This effect is particularly dramatic when a "lattice-matching system" is employed for the light-emitting layer. In other words, the use of either a GaN substrate or other substrates with which a GaN layer enables lattice matching ensures that any mismatch between the lattice constants of the substrate and a layer that is grown thereupon is extremely small, making it possible to greatly reduce the number of crystal defects caused in layers grown thereon, including a light-emitting layer. This "lattice-matching system" of the present invention also makes it possible to further reduce the number of crystal defects generated in the InGaN layer.

The description now turns to the use of GaN as a substrate, by way of example. As the aluminum component of a layer that is grown thereon increases, tensile stresses act in the directions of the boundary surface and compressive stresses act in the direction perpendicular thereto; conversely, as the indium component increases, compressive stresses act in the directions of the boundary surface and tensile stresses act in the direction perpendicular thereto. An InGaN layer will absorb compressive stresses that are generated in the in-plane directions by an AlGaN layer, so that the crystal lattice thereof compresses elastically, providing lattice matching with the underlaying GaN layer. In other words, the present invention makes it possible to configure a "lattice-matching system" that brings the lattice constant of the InGaN of the light-emitting layer closer to that of GaN. As a result, it is possible to greatly reduce the number of crystal defects in the crystal layer and at the boundary surface, even if the indium component of the light-emitting layer is increased.

The present invention also makes it possible to prevent any re-evaporation or decomposition of the InGaN crystal, which causes problems during crystal growth, by growing alternate layers comprising a thin film of indium and layers comprising a thin film of aluminum, making it possible to achieve a good-quality crystal in a reliable manner. As a result, it becomes possible to implement a light-emitting layer with a higher indium component than in the prior art, thus making it possible to implement a brighter light-emitting layer in the red-light range, beyond the wavelengths of green.

If the light-emitting layer has a single InGaN quantum well layer, a similar effect can be obtained by inserting an AlGaN cladding layer as a barrier. If the light-emitting layer has a multiple quantum well structure, all of the barrier layers thereof could be configured of AlGaN, but similar effects can be obtained by a configuration in which InGaN and AlGaN are combined. To obtain emissions at even longer wavelengths, the indium components of InGaN layers sandwiched between AlGaN layers can be made to increase with increasing distance from the substrate side towards the surface, making it possible to implement a good InGaN layer with no deterioration of crystallinity caused by that increase. If a grown layer is formed on a conductive substrate made of GaN or the like, it becomes possible to form an electrode on the rear surface of the substrate, enabling efficient use of the surface area of the wafer.

A second embodiment of the present invention makes it possible to form a "current-blocking structure" in a reliable and also simple manner. It also makes it possible to implement a configuration for ensuring that current does not flow below a bonding pad that blocks the emission of light from the light-emitting layer, by way of example. In other words, if a region comprising an n-side electrode material is formed in part of a region in which a p-side electrode is formed, and is then annealed, the resultant reaction between the metals of those electrodes will form a region with a high contact resistance. If an overcoat electrode consisting of a bonding pad is formed in this high-resistance region, no current will be injected into the light-emitting layer within that portion and thus no light will be emitted thereby. If the n-side electrode material is the same as that of the overcoat electrode of the p-side electrode, it becomes easier and faster to proceed the fabrication process of this structure. The p-side electrode and the semiconductor layer are in contact with a sufficiently low contact resistance outside that region, so that current is injected into the light-emitting layer to generate light therefrom. As the n-side electrode materials, tungsten (W), aluminum (Al), gold (Au), germanium (Ge), titanium (Ti), hafnium (Hf) and vanadium (V) can be preferably used. As the p-side electrode materials, nickel (Ni), platinum (Pt), gold (Au), palladium (Pd), cobalt (Co), magnesium (Mg), vanadium (V), iridium (Ir), rhodium (Rh) and silver (Ag) can be preferably used.

The present invention will now be described in further detail, with reference to specific embodiments thereof.

First Embodiment

The description now turns to specific details of the first embodiment of the present invention.

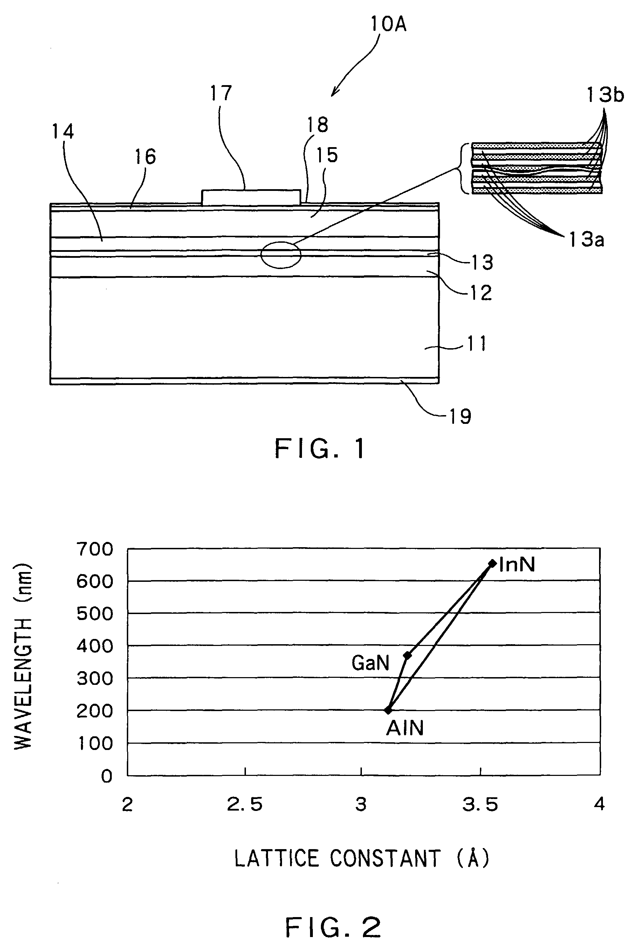

A schematic section through a semiconductor light-emitting element in accordance with this first embodiment of the invention is shown in Fig. 1. In this figure, a light-emitting element 10A is configured of an n-GaN buffer layer 12 (where the n- prefix denotes n-type), an MQW layer (light-emitting layer) 13, a p-AlGaN cladding layer 14 (where the p- prefix denotes p-type), and a p-GaN layer 15, formed in sequence on an n-GaN substrate 11. These crystal layers can be grown by a method such as metal-organic chemical vapor deposition (MOCVD) or molecular beam epitaxy (MBE).

The MQW layer 13 has a configuration in which InGaN well layers 13a and AlGaN barrier layers 13b are formed alternately, as shown in the inset enlargement within Fig. 1. In this case, it is assumed that the thickness of each of the InGaN well layers 13a is on the order of 20 Å and the thickness of each of the AlGaN barrier layers 13b is on the order of 10 Å, where approximately five pairs of these layers could be grown.

A graph of the relationships between the lattice constants in the a-axial direction of GaN, InN, and AlN is shown in Fig. 2.

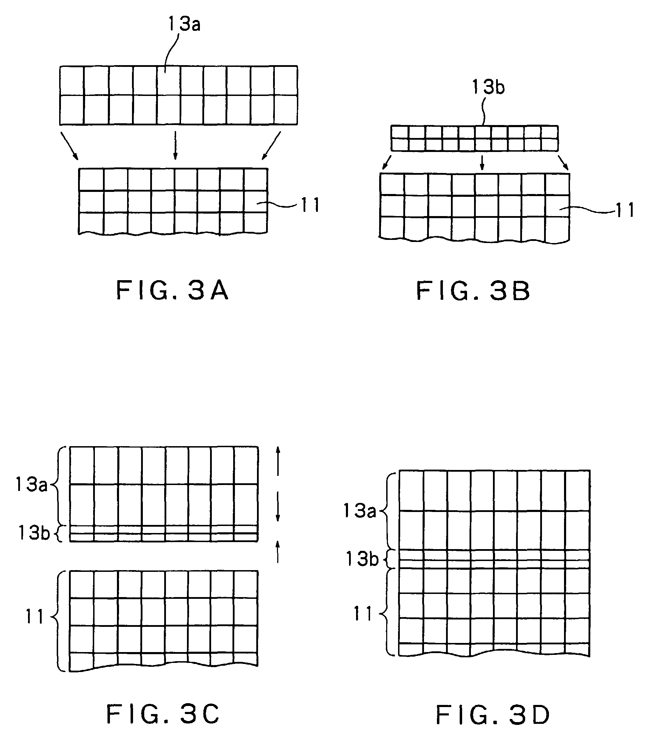

Schematic views of states of lattice-matching that occur when MQW layers are grown in an epitaxial manner on top of a GaN substrate are shown in Figs. 3A-3D. First, Fig. 3A shows the relationship between the lattice constants of the GaN substrate 11 and an InGaN layer 13a, and Fig. 3B shows the relationship between the lattice constants of the GaN substrate 11 and an AlGaN layer 13b. As shown in these figures, the InGaN layer 13a has a larger lattice constant than the GaN substrate 11 and the AlGaN layer 13b has a smaller lattice constant than the GaN substrate 11. If these layers are grown in an epitaxial manner on top of the GaN substrate 11 without any adjustment, therefore, "mismatching" will occur, generating crystal defects at the boundary surface between the crystal layers.

In contrast thereto, if the InGaN layers 13a and the AlGaN layers 13b are formed as thin films, as shown in Fig. 3C, in-plane compressive stresses are applied to the InGaN layers 13a and in-plane tensile stresses are applied to the AlGaN layers 13b. It is aslo possible to adjust the lattice constant of each layer to be extremely close to that of the GaN substrate 11. If the film thickness of each of the InGaN layers 13a and the AlGaN layers 13b is set to be less than the "critical thickness" thereof, in other words, the thickness below which each film is elastically deformable, the generation of crystal defects can be reliably suppressed.

As a result, it is possible to implement extremely good lattice matching, even when those layers are grown epitaxially on top of the GaN substrate 11, as shown in Fig. 3D.

If each layer 13a comprising a high density of indium is grown as an extremely thin layer then is capped immediately by the formation of a thin film of an AlGaN layer 13b, it becomes possible to prevent decomposition and re-evaporation of the InGaN layers 13a and thus implement an increase in the density of indium therein.

It is therefore possible to greatly suppress the generation of crystal defects in the thus formed MQW layer 13, in other words, in the light-emitting layer, even when the indium component of the InGaN layers 13a is set to be high. As a result, it is possible to obtain a light-emitting element which is brighter in the long-wavelength range than in the prior art, and which also has a longer lifetime.

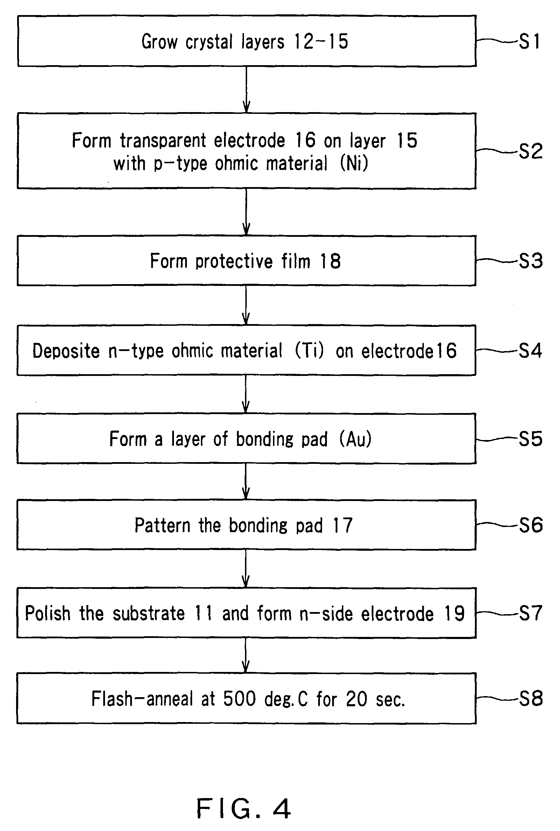

Fig. 4 shows a flow-chart of the fabrication process of the semiconductor light-emitting element 10A. Referring to Fig. 4, the fabrication process will be explained as follows: first, the crystal layers 12 to 15 have been grown epitaxially on the GaN substrate 11. Then, a transparent electrode 16 is formed by the formation of a Ni layer and an Au layer in sequence by an evaporation method on the upper surface of the p-GaN layer 15, an $SiO_2$ film is deposited thereon by a thermal CVD method, then a photo-engraving process (PEP) is used to form a protective film 18 by patterning. A Ti layer, which is the material of an n-side electrode for a p-side bonding pad 17, is then formed by evaporation on the transparent electrode 16 which is exposed in an aperture portion of the protective film 18, then an Au layer or the like is formed thereupon. Patterning of the bonding pad 17 could be done by a lift-off method using resist, by way of example. After the rear surface of the GaN substrate 11 has been polished, an n-side electrode 19 consisting of a Ti layer and an Au layer is formed thereon and is flash-annealed at 500°C for approximately 20 seconds.

If an element is fabricated by this method, an alloying reaction occurs between the transparent Ni/Au electrode 16 and the Ti/Au bonding pad 17 on the p-side during the flash annealing of the n-side electrode 19, increasing the contact resistance with respect to the p-GaN layer 15. This makes it difficult for current to flow under the bonding pad 17, so no light is generated thereby. On the other hand, current spreads within the surface of the transparent electrode 16 outside of the bonding pad 17, so that a uniform emission can be obtained from the flow within the p-GaN layer 15. In other words, emission is efficiently suppressed within the portion below the bonding pad 17 that acts as a light-blocking body, making it possible to increase the efficiency with which light is extracted.

In the above-explained example, the p-type ohmic material (such as Ni) was formed first, then the n-type ohmic material (such as Ti) was partially overcoated thereon. However, the invention is not limited in this specific example. That is, the n-type ohmic material (such as Ti) can be partially deposited on the p-type GaN layer 15 first, then the n-type ohmic material (such as Ni) can be overcated thereon. In this case, a effective current-blocking region can be formed as well.

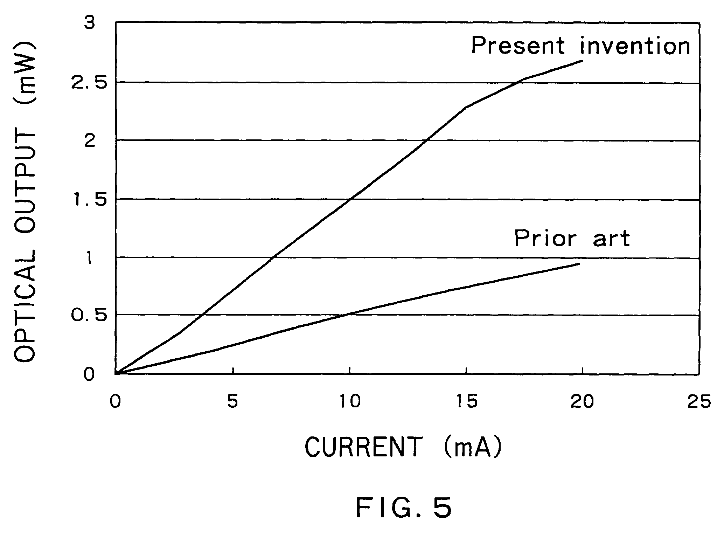

A graph of the current-optical power characteristic of the light-emitting element of this embodiment of the invention is shown in Fig. 5. In this case, the indium component of the InGaN layers 13a of the light-emitting layer 13 is assumed to be 60%. The characteristic of a light-emitting element of the prior-art structure of Fig. 9 is also shown in Fig. 5, for comparison. If the current is 20 mA in the light-emitting element of this invention, a voltage of 3.5 V, an optical output of 2.7 mW, and an emission wavelength of 550 nm are obtained. The optical power obtained from an input current of 20 mA is approximately three times that obtained by the prior-art example.

Note that this embodiment was described as having a high-resistance region in part of the p-side electrode, but it should be obvious that the above described fabrication method is not limited to the p-side electrode and thus it is equally possible to apply this method to the n-side electrode in a similar manner. In other words, if a layer of the material for the p-side electrode is formed in part of the region in which the n-side electrode is formed, then is subjected to moderate thermal processing, it becomes possible to form an alloy between the n-side electrode material and the p-side electrode material, and thus form a high-resistance region in the n-side of the light-emitting layer.

The present invention can also be applied in a similar manner to a configuration in which both the -side electrode and the n-side electrode are formed on the upper-surface side of the substrate, as in the prior-art example shown by way of example in Fig. 9. In such a case, the processing can be made more efficient by making the material of the n-side electrode the same as that of the overcoat electrode, such as gold.

In addition, the light-emitting layer 13 of this embodiment of the invention was described as having a MQW structure formed of InGaN well layers 13a and AlGaN barrier layers 13b, by way of example, but it is not absolutely necessary to have the same proportions of indium or aluminum in all the layers. In other words, varying the amount of strain or the indium component within the InGaN well layers 13a will make it possible to achieve emission at various different wavelengths.

Second Embodiment

The description now turns to specific details of the second embodiment of the present invention.

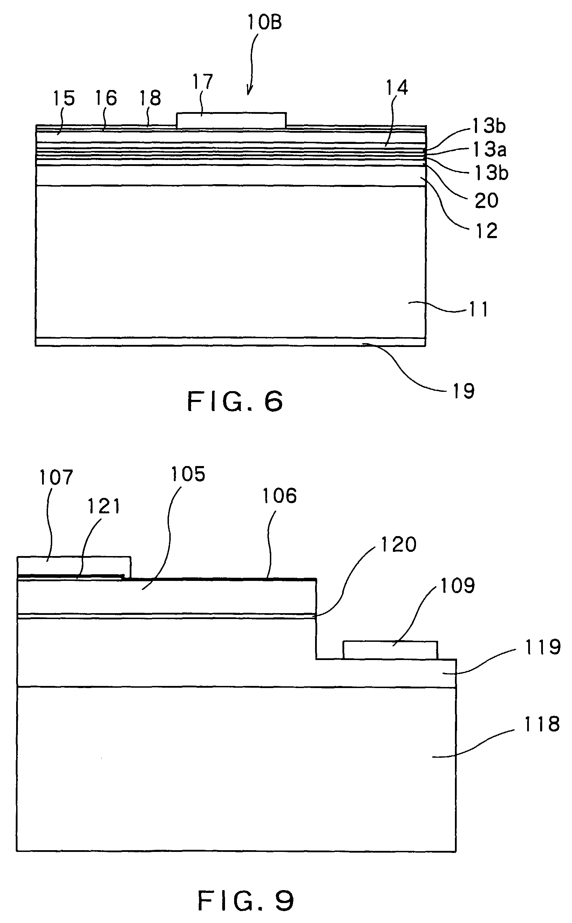

A schematic section through a semiconductor light-emitting element in accordance with this second embodiment of the invention is shown in Fig. 6. Parts of this figure that are similar to portions that have already been described with reference to Fig. 1 are given the same reference numbers and further description thereof is omitted. A light-emitting element 10B in accordance with this embodiment is provided with an n-AlGaN cladding layer 20. The light-emitting layer is configured of one well layer 13a with the AlGaN layers 13b are provided on either two sides or one side thereof, to absorb strain. Note that Fig. 6 shows the case in which the AlGaN layers 13b are provided on two sides of the well layer 13a, by way of example.

These layers 13a and 13b could each be doped with a suitable impurity, or they could be undoped. With this configuration, the amount of strain can be adjusted in accordance with the relationship between the aluminum component of the AlGaN layers 13b and the indium component of the InGaN light-emitting layer 13a to ensure that the strains of the n-AlGaN cladding layer 20, the p-AlGaN cladding layer 14, and the InGaN light-emitting layer 13a are balanced. This makes it possible to control the magnitude of strains more accurately. Cracking is likely to occur if an AlGaN layer is too thick, but this embodiment of the invention has the advantage of enabling a low total thickness.

Note that Fig. 6 shows an example in which only one AlGaN strain layer 13b is provided on each of the p-side and the n-side of the InGaN layer 13a, but it is equally possible to have an AlGaN layer having a plurality of layers with different aluminum components on each side thereof.

Third Embodiment

The description now turns to a third embodiment of the present invention.

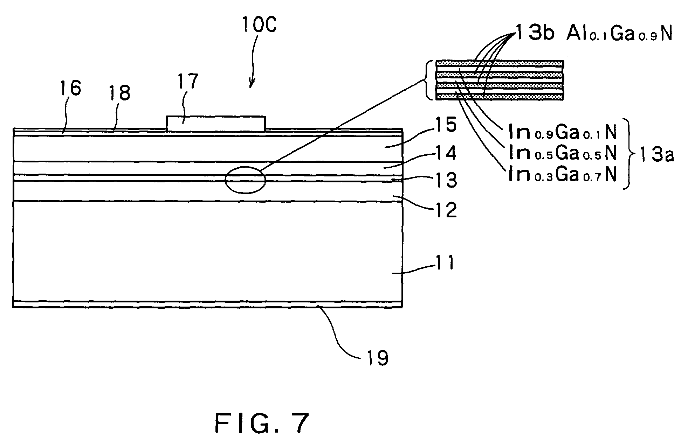

A schematic section through a semiconductor light-emitting element in accordance with this fourth embodiment of the invention is shown in Fig. 7. Parts of this figure that are similar to portions that have already been described with reference to Figs. 1 and 5 are given the same reference numbers and further description thereof is omitted. A light-emitting element 10C in accordance with this embodiment has three well layers 13a. The emission wavelengths thereof are adjusted by varying the indium component in each of these well layers 13a so that red, green, and blue light at wavelengths of 640, 540, and 460 nm is emitted from the upper surface thereof, thus making it possible to obtain white light. Since it is difficult to obtain bright emissions on the longer-wavelength side, this structure ensures an intense emission by emitting light from the upper surface thereof.

However, the converse could also be configured, wherein well layers on the longer-wavelength side, in other words, well layers with higher indium components, are disposed closer to the substrate 11. In other words, the three well layers could be disposed in such a manner that the band gaps thereof increase in sequence from the substrate side. This configuration makes it possible to prevent a situation in which the light emitted by the substrate-side well layer is absorbed by well layers on the upper side thereof.

It is also possible to implement white light by ensuring that ultraviolet that is emitted from the light-emitting element strikes a fluorescent material so that the color thereof changes (for example, to red light that is difficult to obtain with sufficient brightness), and combining light that is emitted from the wells. As an example: if the indium component of each well layer in this configuration is assumed to be 0.02, 0.3, and 0.5, in sequence from the upper surface, the emission wavelength of each layer will be 370, 460, and 540 nm, respectively. Of these, if the ultraviolet light at 370 nm strikes a fluorescent body and is converted into red light, it is possible to obtain white light by combining the red light with emissions of blue and green light from the wells.

Fourth Embodiment

The description now turns to a fourth embodiment of the present invention.

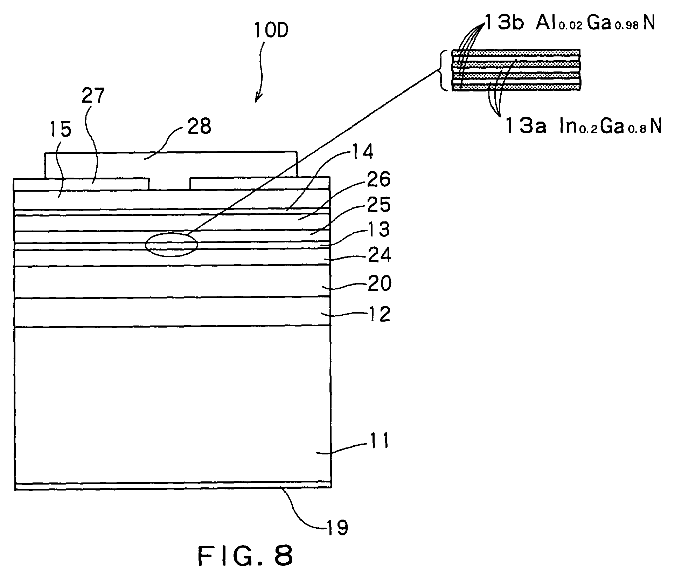

A schematic section through a semiconductor light-emitting element in accordance with this fourth embodiment of the invention is shown in Fig. 8. Parts of this figure that are similar to portions that have already been described with reference to Figs. 1, 5, and 6 are given the same reference numbers and further description thereof is omitted. A light-emitting element 10D in accordance with this embodiment is a semiconductor laser. An n-GaN guide layer 24, a MQW type of light-emitting layer 13, a p-AlGaN layer 25, and a p-GaN guide layer 26 are provided in that sequence on top of the n-AlGaN cladding layer 20, then the p-AlGaN cladding layer 14 and the p-GaN layer 15 are formed thereupon.

The light-emitting layer 13 can have the same MQW structure as that shown in Fig. 1, for example. In this case, the indium component of each of the InGaN layers 13a can be 0.2 and the aluminum component of each of the AlGaN layers 13b can be 0.02.

To ensure that the current is injected in a stripe shape into the light-emitting layer from above the p-GaN layer 15, an isolation film 27 having a stripe-shaped aperture is provided thereon and a p-side electrode 28 is provided on top of the isolation film 27.

This embodiment of the invention makes it possible to obtain a stable laser light beam that has a longer wavelength and a higher power than in the prior art.

Note that an n-side electrode material could be provided instead of the isolation film 27, in a similar manner to that described with reference to the first embodiment. In other words, a film of the n-side electrode material having a stripe-shaped aperture could be formed on top of the p-GaN layer 15, then the resistance of the region on the outer sides of the stripe could be increased by forming a p-side electrode over the entire upper surface and subjecting the assembly to thermal processing.

The present invention has been described above with reference to specific embodiments thereof. However, it should be noted that the present invention is not limited to those embodiments.

For example, the substrate used in embodying this invention is not limited to GaN and thus should be obvious that other materials can achieve similar effects, provided there is only a small amount of mismatch with respect to GaN. For example, the use of materials such as $MnO$, $NdGaO_3$, $ZnO$, $LiAlO_2$, and $LiGaO_2$ makes it possible to restrain the lattice mismatching with respect to the GaN layer to within approximately 2%. If a substrate of such a material is used, therefore, satisfactory lattice matching can be achieved with the GaN layer, making it possible to achieve the effects of the present invention.

The method relating to electrode formation that was described for the second embodiment of this invention is not limited to a gallium nitride semiconductor light-emitting element, and thus similar effects can be achieved when it is applied to light-emitting elements of semiconductors formed of other materials. For example, the present invention can be applied in a similar manner to semiconductor light-emitting elements formed of various other semiconductor materials, such as those in the GaP, GaAsP, AlGaInP, GaAlP, InP, InGaAs, and InGaAsP families.

While the present invention has been disclosed in terms of the preferred embodiment in order to facilitate better understanding thereof, it should be appreciated that the invention can be embodied in various ways without departing from the principle of the invention. Therefore, the invention should be understood to include all possible embodiments and modification to the shown embodiments which can be embodied without departing from the principle of the invention as set forth in the appended claims.

The entire disclosure of Japanese Patent Application No.H11-227283 filed on August 11, 1999 including specification, claims, drawings and summary is incorporated herein by reference in its entirety.

**Claims**

1. A semiconductor light-emitting element comprising:

   a substrate; and
   a light-emitting layer disposed on a main surface of said substrate,
   said light-emitting layer having:
   a first layer formed of a nitride semiconductor having a lattice constant that is larger than that of said substrate; and
   a second layer formed of a nitride semiconductor having a lattice constant that is smaller than that of said substrate,
   said first layer being compressed by said second layer in a substantially elastic manner in directions parallel to said main surface so as to reduce a difference in lattice constant with respect to said substrate.

2. The semiconductor light-emitting element according to claim 1, wherein

   said first layer is formed of $In_xGa_{(1-x)}N$ (where $0 \leqq x \leqq 1$), and
   said second layer is formed of $Al_yGa_zIn_{(1-y-z)}N$ (where $0 < y \leqq 1$, $0 \leqq z \leqq 1$, and $y + z \leqq 1$).

3. The semiconductor light-emitting element according to claim 1, wherein said first layer has a thickness on the order of the wavelength of the de Broglie wave of electrons.

4. The semiconductor light-emitting element according to claim 1, wherein said substrate is formed of a material that enables substantial lattice-matching with respect to GaN.

5. The semiconductor light-emitting element according to claim 1, wherein said substrate is formed of GaN.

6. The semiconductor light-emitting element according to claim 1, wherein

    said light-emitting layer comprises a plurality of said first layers and a plurality of said second layers, formed alternately, and
    at least one layer of said plurality of first layers has a band gap that differs from that of another of said first layers.

7. The semiconductor light-emitting element as defined in claim 1, wherein

    said light-emitting layer comprises a plurality of said first layers and a plurality of said second layers, formed alternately, and
    at least one layer of said plurality of first layers emits light of a different wavelength from that of another first layer, by absorbing a different amount of said compression from a neighboring second layer than said other first layer.

8. The semiconductor light-emitting element according to claim 6, wherein white light is obtained by combining light emitted by each of said plurality of first layers.

9. The semiconductor light-emitting element according to claim 1 further comprising a stripe-shaped cavity for a laser oscillation,

    at least a part of said light-emitting layer being arranged in said stripe-shaped cavity.

10. A semiconductor light-emitting element comprising:

    a semiconductor of a first conductivity type; and
    an electrode provided in contact with said semiconductor of said first conductivity type,
    a contact portion between said semiconductor and said electrode including a first region having a lower contact resistance and a second region having a higher contact resistance,
    a first metal that enables ohmic-like contact with respect to said semiconductor of said first conductivity type being placed in contact with said semiconductor of said first conductivity type within said first region, and
    a mixed body formed of said first metal and a second metal that enables ohmic-like contact with respect to a semiconductor of a second conductivity type being placed in contact with said semiconductor of said first conductivity type within said second region,
    said second metal being different from said first metal.

11. The semiconductor light-emitting element according to claim 10, wherein

    said semiconductor is formed of a nitride semiconductor,
    said first metal includes one of tungsten (W), aluminum (Al), gold (Au), germanium (Ge), titanium (Ti), hafnium (Hf) and vanadium (V), and
    said second metal includes one of nickel (Ni), platinum (Pt), gold (Au), palladium (Pd), cobalt (Co), magnesium (Mg), vanadium (V), iridium (Ir), rhodium (Rh) and silver (Ag).

12. The semiconductor light-emitting element according to claim 10, wherein

    said semiconductor is formed of a nitride semiconductor,
    said first metal includes one of nickel (Ni), platinum (Pt), gold (Au), palladium (Pd), cobalt (Co), magnesium (Mg), vanadium (V), iridium (Ir), rhodium (Rh) and silver (Ag), and
    said second metal includes one of tungsten (W), aluminum (Al), gold (Au), germanium (Ge), titanium (Ti), hafnium (Hf) and vanadium (V).

13. The semiconductor light-emitting element according to claim 10, wherein a light is extracted through said first region.

14. The semiconductor light-emitting element according to claim 10 further comprising a bonding pad provided on said second region.

15. The semiconductor light-emitting element according to claim 10 further comprising a stripe-shaped cavity for a laser oscillation,

    said first region being formed in a stripe shape on said cavity, and
    said second region being formed on both side of said stripe-shaped first region.

16. A method of fabricating a semiconductor light-emitting element, comprising:

a first depositing step for depositing a first metal that enables ohmic-like contact with respect to a semiconductor of a first conductivity type, on an upper surface of said semiconductor of said first conductivity type;

a second depositing step for depositing a second metal that enables ohmic-like contact with respect to the semiconductor if the semiconductor is of a second conductivity type, on part of said upper surface of said semiconductor of said first conductivity type; and

an alloying step for forming a region with a higher contact resistance with respect to said semiconductor of said first conductivity type, by causing a reaction between said first metal and said second metal,

said second metal being different from said first metal.

17. The method of fabricating a semiconductor light-emitting element according to claim 16, wherein said first depositing step is performed before said second depositing step.

18. The method of fabricating a semiconductor light-emitting element according to claim 16, wherein said alloying step includes annealing process.

19. The method of fabricating a semiconductor light-emitting element according to claim 16, wherein

said first conductivity type is a p-type,
said second conductivity type is an n-type,
said semiconductor is nitride semiconductor,
said first metal includes one of nickel (Ni), platinum (Pt), gold (Au), palladium (Pd), cobalt (Co), magnesium (Mg), vanadium (V), iridium (Ir), rhodium (Rh) and silver (Ag), and
said second metal includes one of tungsten (W), aluminum (Al), gold (Au), germanium (Ge), titanium (Ti), hafnium (Hf) and vanadium (V).

20. The method of fabricating a semiconductor light-emitting element according to claim 16, further comprising a step for forming a bonding pad on said region with the higher contact resistance.

FIG. 1

FIG. 2

FIG. 3A

FIG. 3B

FIG. 3C

FIG. 3D

```
┌─────────────────────────────────────────────────┐
│            Grow crystal layers 12-15            │──S1
└─────────────────────────────────────────────────┘
                        │
                        ▼
┌─────────────────────────────────────────────────┐
│       Form transparent electrode 16 on layer 15 │──S2
│          with p-type ohmic material (Ni)        │
└─────────────────────────────────────────────────┘
                        │
                        ▼
┌─────────────────────────────────────────────────┐
│              Form protective film 18            │──S3
└─────────────────────────────────────────────────┘
                        │
                        ▼
┌─────────────────────────────────────────────────┐
│  Deposite n-type ohmic material (Ti) on electrode16 │──S4
└─────────────────────────────────────────────────┘
                        │
                        ▼
┌─────────────────────────────────────────────────┐
│           Form a layer of bonding pad (Au)      │──S5
└─────────────────────────────────────────────────┘
                        │
                        ▼
┌─────────────────────────────────────────────────┐
│             Pattern the bonding pad 17          │──S6
└─────────────────────────────────────────────────┘
                        │
                        ▼
┌─────────────────────────────────────────────────┐
│  Polish the substrate 11 and form n-side electrode 19 │──S7
└─────────────────────────────────────────────────┘
                        │
                        ▼
┌─────────────────────────────────────────────────┐
│       Flash-anneal at 500 deg.C for 20 sec.     │──S8
└─────────────────────────────────────────────────┘
```

FIG. 4

FIG. 5

EP 1 076 390 A2

FIG. 6

FIG. 9

FIG. 7

$13b \ Al_{0.02}Ga_{0.98}N$

$13a \ In_{0.2}Ga_{0.8}N$

FIG. 8